# EUROPÄISCHE PATENTANMELDUNG

(11) **EP 3 951 456 A1**
(43) Veröffentlichungstag der Anmeldung: **09.02.2022**
(21) Anmeldenummer: 20189632.1
(22) Anmeldetag: 05.08.2020
(51) Int. Cl.: G02B 6/00, G02B 6/44, G01R 31/34, H01B 9/00, H02H 1/00, H02K 11/22

(54) **WICKLUNGSSYSTEM FÜR EINE DYNAMOELEKTRISCHE MASCHINE, DYNAMOELEKTRISCHE MASCHINE**

(71) Anmelder: Siemens Aktiengesellschaft, 80333 München (DE)
(72) Erfinder: Katzenberger, Tobias, 97631 Bad Königshofen STT Untereßfeld (DE); Plochmann, Bastian, 91413 Neustadt an der Aisch (DE)

(57) **Zusammenfassung**

Die Erfindung betrifft ein Wicklungssystem für eine dynamoelektrische Maschine (8), aufweisend eine Mehrzahl an Einzeldrähten (2), wenigstens einen Lichtwellenleiter (4), wobei der Lichtwellenleiter (4) derart ausgebildet ist, dass eine elektromagnetische Strahlung im optischen Frequenzbereich detektierbar ist. Die Erfindung betrifft zudem eine dynamoelektrische Maschine (8), aufweisend einen Rotor (14) und einen Stator (13), wobei der Stator (13) ein Statorpaket und ein derartiges Wicklungssystem aufweist. Die Erfindung betrifft zudem einen Antrieb.

## Beschreibung

Die Erfindung betrifft ein Wicklungssystem für eine dynamoelektrische Maschine, eine dynamoelektrische Maschine sowie einen Antrieb.

Insbesondere Niederspannungsmotoren bis 1 kV sind historisch bedingt mit einem per Definition teilentladungsfreien, also einem gemäß IEC 60034-18-41 Typ II gestalteten, Isoliersystem ausgestattet. Hiernach sollen lokale Feldstärken unterhalb einer Teilentladungseinsetzfeldstärke (auch: TE-Einsetzfeldstärke) liegen.

In letzter Zeit wurden jedoch Isolationsdicken immer weiter reduziert, Bauraum verkleinert sowie eine Leistungsdichte erhöht. Außerdem wird bei Imprägnierverfahren zunehmend auf kostengünstige Tränkprozesse gesetzt, welche eine oftmals fehlerhafte Imprägnierung liefern, insbesondere verursacht durch Poren, Lufteinschlüsse oder einen zu geringen Harzgehalt.

Durch einen hohen thermischen und visuellen Energieeintrag von Teilentladungen, insbesondere in Form eines UV-Lichtblitzes in vorhandene Grenzflächen kommt es zu einem zunehmenden Abbau von Kunststoff (auch Degradation genannt), was zu einem Abbau eines Isolationssystems führt (auch Erosion genannt). Auf diese Weise kommt es zum Verlust der Isolationswirkung und die elektrische Maschine wird zerstört.

Eine Grenzfläche ist z. B. ein Übergang von Luft zu Kunststoff, insbesondere eine Pore. Ein Lufteinschluss entsteht z.B. durch einen mangelhaften Imprägnierprozess.

Es gibt weitere Grenzflächen, z. B. eine Luft-Drahtlack-Grenzfläche, eine Luft-Imprägnierharz-Grenzfläche oder ein Tripelpunkt.

Da eine Schädigung des Isolationssystems schleichend verläuft, bleibt diese oft unbemerkt. Der Erfindung liegt die Aufgabe zugrunde, dies zu verbessern.

Die Lösung der Aufgabe gelingt durch Anspruch 1, d. h. ein Wicklungssystem für eine dynamoelektrische Maschine, aufweisend eine Mehrzahl an Einzeldrähten und wenigstens einen Lichtwellenleiter, wobei der Lichtwellenleiter derart ausgebildet ist, dass eine elektromagnetische Strahlung im optischen Frequenzbereich detektierbar ist.

Alternativ weist das Wicklungssystem eine Mehrzahl an Lichtwellenleitern auf.

Die Erfindung bietet den Vorteil einer in-situ Teilentladungsdetektion.

Im Gegensatz zu elektrischen und thermischen Messverfahren wird durch die Erfindung keine elektrische Feldverzerrung im Aktivteil hervorgerufen und somit der Wirkungsgrad der Maschine nicht beeinflusst.

Durch eine Detektion und Lokation von Teilentladungen während des Betriebs ist es möglich, Schäden und Ausfälle von Maschinen zu verhindern.

In einer vorteilhaften Ausführung ist der Lichtwellenleiter derart ausgebildet, dass die elektromagnetische Strahlung im optischen Frequenzbereich lokalisierbar ist.

Die Art und Weise einer Lokalisierung wird weiter unten ausgeführt.

In einer vorteilhaften Ausführung ist der Lichtwellenleiter derart ausgebildet, dass eine Ultraviolettstrahlung detektierbar ist.

Die elektromagnetische Strahlung im optischen Frequenzbereich reicht vorzugweise von 380 bis 100 nm.

Eine Teilentladung erzeugt zumeist einen UV-Lichtblitz, der auf diese Weise detektierbar ist.

In einer vorteilhaften Ausführung ist der Lichtwellenleiter in einem zwischen wenigstens zwei Einzeldrähten liegenden Zwickel angeordnet.

Die Einzeldrähte weisen vorteilhaft wenigstens im Wesentlichen einen runden und/oder ovalen Querschnitt auf. Die Anordnung im Zwickel ist von Vorteil, da dadurch ein bisher ungenutzter Raum im Wicklungssystem verwendet wird. Jedoch sind auch andere Anordnungen denkbar.

In einer vorteilhaften Ausführung sind die Einzeldrähte und der Lichtwellenleiter zu Spulen gewickelt.

Bei einer Herstellung von dynamoelektrischen Maschinen werden vorteilhaft zunächst Einzeldrähte über Wickeleinziehautomaten zu Spulen gewickelt und im Anschluss in das Statorpaket, das insbesondere als Blechpaket ausgeführt ist, eingezogen. Der Lichtwellenleiter kann somit direkt in die Spulen eingewickelt werden. So kann dieser als optischer Sensor für auftretende UV-Blitze im Wicklungssystem fungieren.

In einer vorteilhaften Ausführung weist der Lichtwellenleiter ein für die elektromagnetische Strahlung im optischen Frequenzbereich wenigstens im Wesentlichen transparentes Material auf.

Ist ein Material für einfallende elektromagnetische Strahlung eines mehr oder weniger breiten Frequenzspektrums transparent, kann die Strahlung das Material nahezu vollständig durchdringen und wird so kaum reflektiert und absorbiert.

In einer vorteilhaften Ausführung weist der Lichtwellenleiter Glas und/oder Polymethylmethacrylat (auch PMMA genannt) auf.

In einer vorteilhaften Ausführung weist der Lichtwellenleiter eine Dicke zwischen 10 µm und 2 mm auf.

Der Lichtwellenleiter ist vorzugsweise als dünne Faser ausgebildet.

Der Lichtwellenleiter weist vorzugsweise eine Mantelfläche auf und ist vorteilhaft derart ausgebildet, dass aufgrund einer Grenzflächenreflexion an der Mantelfläche Lichtstrahlen als Lichtwellen innerhalb der Faser bis zum Ende der Faser transportiert werden. Eine Laufzeit der Lichtwellen im Lichtwellenleiter ist dabei messbar. Somit ist eine zurückgelegte Strecke des Lichts berechenbar.

Auf diese Weise ist eine elektromagnetische Strahlung im optischen Frequenzbereich nicht nur detektierbar, sondern sogar lokalisierbar.

Auf diese Weise können Teilentladungen, welche sich als UV-Blitze bemerkbar machen, besonders gut detektiert werden.

In einer vorteilhaften Ausführung weist der Lichtwellenleiter eine Dotierung auf.

Vorteilhaft ist hierbei eine Dotierung im Sinne von optischen Streuzentren, angeordnet im Volumen des Lichtwellenleiters und/oder an seiner Oberfläche. Ein optisches Streuzentrum kann hierbei ein kristalliner Bereich sein. Ein optisches Streuzentrum kann ferner ein Partikel sein, welche andere optische Eigenschaften wie der Lichtwellenleiter an sich hat zur Erreichung einer Grenzflächenreflexion.

In einer vorteilhaften Ausführung weist der Lichtwellenleiter eine Perforation, insbesondere an einer Mantelfläche des Lichtwellenleiters, auf.

Ein Aspekt der Erfindung ist eine Einkopplung der Lichtstrahlen, welche typischerweise aufgrund der Reflexion der Mantelfläche meist über eine Stirnfläche des Lichtwellenleiters erfolgt. Hierzu ist eine Dotierung des Lichtwellenleiters sinnvoll, d.h. ein bewusstes Einbringen von Streuzentren in ein sonst transparentes Material. Auf diese Weise werden Lichtstrahlen, welche in einem stumpfen Winkel durch die Mantelfläche strömen, an diesen Streuzentren gestreut und sind somit im Lichtwellenleiter "gefangen".

Eine weitere Möglichkeit ist die Perforation der Mantelfläche z.B. mittels mechanischer Einwirkung. Eine z.B. aufgeraute Oberfläche ist hierbei hilfreich, da sich lokal ein Auftreffwinkel der Lichtstrahlen derart ändert, dass eine Einleitung in den Lichtwellenleiter gelingt.

In einer vorteilhaften Ausführungsform weisen die Einzeldrähte am Außenumfang eine Isolierung auf.

Diese Isolierung ist beispielsweise Lack, insbesondere Drahtlack. Typische Drahtlacke sind z. B. Multilagen, aufweisend Polyamidimid (PAI), Polyethylenterephthalat (PET) und/oder Polyimid (PI).

Es sind auch andere Materialien denkbar.

Die Lösung der oben gestellten Aufgabe gelingt ferner durch Anspruch 12, d. h. eine dynamoelektrische Maschine, aufweisend einen Rotor und einen Stator, wobei der Stator ein Statorpaket und ein derartiges Wicklungssystem aufweist.

In einer vorteilhaften Ausführung weist die dynamoelektrische Maschine wenigstens eine Photodiode zur Aufnahme eines Strahlungsauftretens auf.

Das Strahlungsauftreten ist vorzugsweise ein UV-Lichtblitz infolge einer Teilentladung.

In einer vorteilhaften Ausführung ist die Photodiode in einem Klemmkasten angeordnet.

Die Lösung der Aufgabe gelingt zudem durch Anspruch 15, d. h. einen Antrieb, aufweisend eine dynamoelektrische Maschine und einen Umrichter, wobei der Antrieb derart ausgebildet ist, dass, insbesondere mittels Cloud-Computing, ein Auftreten einer elektromagnetischen Strahlung im optischen Frequenzbereich übermittelbar ist.

Dies hat den Vorteil, dass der Antrieb auf die Teilentladung bzw. auf eine Mehrzahl an Teilentladungen reagieren und Maßnahmen ergreifen kann. Hierzu zählen mitunter eine Warnung an den Service, ein Hinweis auf Wartungsarbeiten, eine Drosselung von Spannungen oder andere Maßnahmen, die eine Sicherheit des Antriebs gewährleisten.

Die Erfindung bietet den Vorteil, dass mit Stoßspannungen und Rechteckspannungen ein Betriebsverhalten der Maschine exakt und effizient gesteuert werden kann. Denn gepulste Spannungen, bzw. Rechteckspannungen werden meist durch Superpositionen hochfrequenter Spannungsanteile gebildet und somit werden durch Reflexionen und Induktivitäten in einer Maschinenwicklung einzelne hochfrequente Spannungspulse mit großer Amplitude erzeugt. In kritischen Bereichen, z.B. bei Drahtkreuzungen mit ungünstigen Potentialverhältnissen, ist mit einer deutlich höheren Spannungsdifferenz, als für das Isolationssystem zugelassen ist, zu rechnen. In vorhandenen Poren wird somit ein Paschenminimum überschritten und es zünden Teilentladungen in einem nicht teilentladungsresistenten Isolationssystem. Die Erfindung bietet den Vorteil, dass in diesen Fällen Teilentladungen detektiert werden können und ein Risiko für die Maschine abgeschätzt werden kann.

Im Folgenden wird die Erfindung anhand der in den Figuren dargestellten Ausführungsbeispiele näher beschrieben und erläutert. Es zeigen:
- FIG 1: einen Querschnitt durch ein Wicklungssystem,
- FIG 2: einen Antrieb, der zur Kommunikation mit der Cloud ausgebildet ist,
- FIG 3: eine dynamoelektrische Maschine,
- FIG 4 bis FIG 7: verschiedene Ausführungen eines Lichtwellen-leiters.

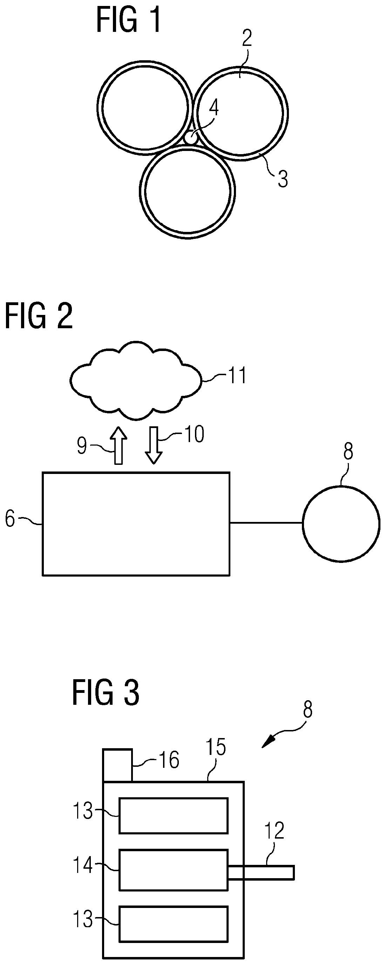

FIG 1 zeigt einen Querschnitt durch ein Wicklungssystem. Dieses umfasst drei zentrisch angeordnete Einzeldrähte 2. Die Einzeldrähte weisen z. B. Kupfer und/oder Aluminium auf.

Die Einzeldrähte 2 weisen an ihrem Außenumfang eine Isolation 3 auf. Die Einzeldrähte 2 sind beispielsweise als Lackdrähte ausgeführt.

In einem mittig angeordneten Zwickel ist in der Figur ein Lichtwellenleiter 4 angeordnet.

Ein Durchmesser des Lichtwellenleiters ist dabei so zu wählen, dass dieser sich in den Zwickel schmiegt.

Der Zwickel wird vorteilhaft in einem, vorzugsweise anschließenden, Imprägnierverfahren zu einem gewissen Teil mit Imprägnierharz gefüllt.

Der eingebrachte Lichtwellenleiter 4, vorzugsweise eine eingebrachte Glasfaser, hat keinen Einfluss auf eine Kupferfüllung (also ein Aktivmaterial) in einer Statornut und somit auch keinen Einfluss auf elektrische Leistungsdaten der Maschine.

Eine sensorische Überwachung durch Lichtwellenleiter hat hierbei den Vorteil, dass ein Lichtwellenleitermaterial elektrisch isolierender Kunststoff oder eine elektrisch isolierende Glasart umfasst. Somit werden elektrische Eigenschaften der Maschine nicht beeinträchtigt.

Eine Anzahl von Lichtwellenleiter-Windungen im Verhältnis zu Einzeldraht-Windungen kann variabel eingestellt werden, wobei eine gewünschte Ortsauflösung und Sensorik-Genauigkeit in Betracht gezogen werden muss.

FIG 2 zeigt einen Antrieb, der zur Kommunikation mit der Cloud 11 ausgebildet ist.

Der Antrieb umfasst einen Umrichter 6 sowie eine dynamoelektrische Maschine 8. Die Maschine 8 weist das bereits erläuterte Wicklungssystem auf. Der Antrieb ist derart ausgebildet, dass, insbesondere mittels Cloud-Computing, ein Auftreten einer elektromagnetischen Strahlung im optischen Frequenzbereich übermittelbar ist.

Eine Übermittlung eines derartigen Auftretens ist angedeutet durch einen Pfeil 9.

Dies bietet den Vorteil, dass der Antrieb in einer modernen IoT-Anwendung regulieret werden kann. Gerade bei größeren Maschinen (z. B. > 45kW) ist ein Ausfall mit hohen Kosten verbunden. Auch eine damit verbundene Stillstandszeit der Gesamtanlage hat meist hohe Kosten zur Folge. Die Erfindung trägt dazu bei, diese Ausfallzeiten zu reduzieren oder sogar ganz zu verhindern. Dies wirkt sich positiv auf eine Kostenreduzierung und auf eine Produktivität der Gesamtanlage bei.

Mittels der Cloud 11 und wie durch den Pfeil 10 angedeutet sind Anweisungen an den Antrieb übermittelbar, z. B. Anweisungen zur Änderung einer Größe wie Spannung, Drehzahl oder Drehmoment.

FIG 3 zeigt die dynamoelektrische Maschine 8. Die Maschine 8 ist vorzugsweise als dynamoelektrische rotatorische Maschine ausgebildet.

Die Maschine 8 umfasst einen Stator 13, einen Rotor 14 und eine Welle 12. Der Stator 13 umfasst das beschriebene Wicklungssystem. Die Maschine 8 ist in der Figur mittels eines Gehäuses 15 eingehaust. Zudem weist die Maschine 8 einen Klemmkasten 16 auf, welcher vorteilhaft eine Photodiode (nicht dargestellt) beinhaltet.

Eine Aufnahme der durch Teilentladungen erzeugten UV-Lichtblitze wird über die Photodiode im Klemmkasten 16 bewerkstelligt.

Aufgrund einer Kenntnis über Leitungslängen und einen Windungsaufbau in der Maschine kann mittels einer Lichtlaufzeit der exakte Ort der eingekoppelten Strahlung ermittelt werden.

Durch Ankopplung beider Leitungsenden des Lichtwellenleiters kann zudem ein Messergebnis verbessert werden. Eine zeitliche Aufnahme einer Strahlungsintensität in einem bestimmten Lichtlaufzeitbereich (auch Ortsbereich) gibt Aufschluss über eine ggf. fortschreitende Erosion eines Isoliermaterials über die damit einhergehende Erhöhung einer Teilentladungsintensität.

Somit können Fehlerszenarien in-situ aufgezeichnet werden und Prognosemodelle zum Schädigungsverlauf und einem möglichen Ausfall der Maschine erstellt werden. Schadensfälle können somit viel früher und nicht erst bei einem Ausfall der Maschine erkannt werden.

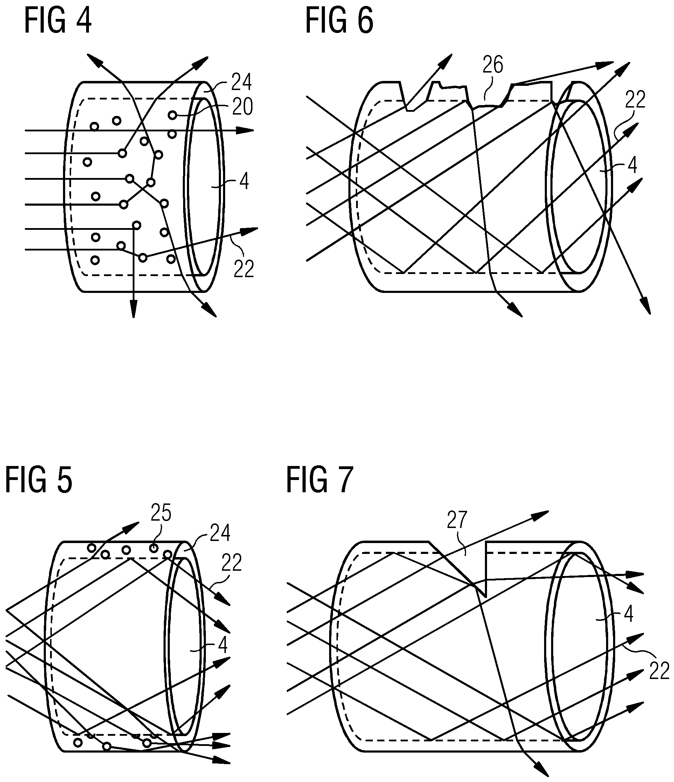

Die FIG 4 bis FIG 7 zeigen beispielhaft verschiedene Ausführungen eines Lichtwellenleiters 4.

Der Lichtwellenleiter weist z. B. Glas, PMMA und/oder ein anderen UV-Licht transparentes Material auf und ist vorteilhaft als sehr dünne Faser mit einem Durchmesser zwischen 10 µm und 2 mm ausgeführt.

Aufgrund einer Grenzflächenreflexion an einer Mantelfläche 24 sind Lichtstrahlen 22 innerhalb der Faser bis zum Ende der Faser transportierbar. Eine Lichtwellenlaufzeit ist dabei messbar. Eine zurückgelegte Strecke des Lichts ist somit berechenbar.

Ein wichtiger Aspekt der Erfindung ist eine Einkopplung der Lichtstrahlen 22, welche typischerweise aufgrund einer Reflexion der Mantelfläche 24 vorteilhaft über Stirnflächen erfolgt.

Hierzu ist, wie FIG 4 und FIG 5 zeigen, eine Dotierung des Lichtwellenleiters 4 sinnvoll, d.h. ein bewusstes Einbringen von Streuzentren 20 bzw. 25 in ein sonst wenigstens im Wesentlichen transparentes Lichtwellenleitermaterial, sodass Lichtstrahlen 22, welche in einem stumpfen Winkel durch die Mantelfläche 24 strömen, an diesen Streuzentren 20 bzw. 25 gestreut werden und somit im Lichtwellenleiter 4 gefangen sind.

Eine weitere Möglichkeit ist, wie FIG 6 und FIG 7 zeigen, eine Perforation 26 bzw. 27 der Mantelfläche 24, z.B. mittels mechanischer Einwirkung. Eine Oberfläche des Lichtwellenleiters 4 ist hierbei aufgeraut, sodass sich lokal ein Auftreffwinkel der Lichtstrahlen 22 derart ändert, dass eine Einleitung in den Lichtwellenleiter 4 gelingt.

## Patentansprüche

1. Wicklungssystem für eine dynamoelektrische Maschine (8), aufweisend
- eine Mehrzahl an Einzeldrähten (2),
- wenigstens einen Lichtwellenleiter (4), wobei der Lichtwellenleiter (4) derart ausgebildet ist, dass eine elektromagnetische Strahlung im optischen Frequenzbereich detektierbar ist.

2. Wicklungssystem nach Anspruch 1, wobei der Lichtwellenleiter (4) derart ausgebildet ist, dass die elektromagnetische Strahlung im optischen Frequenzbereich lokalisierbar ist.

3. Wicklungssystem nach einem der vorhergehenden Ansprüche, wobei der Lichtwellenleiter (4) derart ausgebildet ist, dass eine Ultraviolettstrahlung detektierbar ist.

4. Wicklungssystem nach einem der vorhergehenden Ansprüche, wobei der Lichtwellenleiter (4) in einem zwischen wenigstens zwei Einzeldrähten (2) liegenden Zwickel angeordnet ist.

5. Wicklungssystem nach einem der vorhergehenden Ansprüche, wobei die Einzeldrähte (2) und der Lichtwellenleiter (4) zu Spulen gewickelt sind.

6. Wicklungssystem nach einem der vorhergehenden Ansprüche, wobei der Lichtwellenleiter (4) ein für die elektromagnetische Strahlung im optischen Frequenzbereich wenigstens im Wesentlichen transparentes Material aufweist.

7. Wicklungssystem nach einem der vorhergehenden Ansprüche, wobei der Lichtwellenleiter (4) Glas und/oder Polymethylmethacrylat aufweist.

8. Wicklungssystem nach einem der vorhergehenden Ansprüche, wobei der Lichtwellenleiter (4) eine Dicke zwischen 10 µm und 2 mm aufweist.

9. Wicklungssystem nach einem der vorhergehenden Ansprüche, wobei die Einzeldrähte (2) am Außenumfang eine Isolierung (3) aufweisen.

10. Wicklungssystem nach einem der vorhergehenden Ansprüche, wobei der Lichtwellenleiter (4) eine Dotierung (20, 25) aufweist.

11. Wicklungssystem nach einem der vorhergehenden Ansprüche, wobei der Lichtwellenleiter (4) eine Perforation (26, 27), insbesondere an einer Mantelfläche (24) des Lichtwellenleiters (4), aufweist.

12. Dynamoelektrische Maschine (8), aufweisend
- einen Rotor (14),
- einen Stator (13), wobei der Stator (13) ein Statorpaket und ein Wicklungssystem nach einem der Ansprüche 1 bis 11 aufweist.

13. Dynamoelektrische Maschine (8) nach Anspruch 12, aufweisend wenigstens eine Photodiode zur Aufnahme eines Strahlungsauftretens.

14. Dynamoelektrische Maschine (8) nach einem der Ansprüche 12 oder 13, wobei die Photodiode in einem Klemmkasten (16) angeordnet ist.

15. Antrieb, aufweisend eine dynamoelektrische Maschine (8) nach einem der Ansprüche 10 bis 12 und einen Umrichter (6), wobei der Antrieb derart ausgebildet ist, dass, insbesondere mittels Cloud-Computing, ein Auftreten einer elektromagnetischen Strahlung im optischen Frequenzbereich übermittelbar ist.
